# EUROPÄISCHE PATENTSCHRIFT

(11) **EP 1 938 398 B1**
(45) Veröffentlichungstag und Bekanntmachung des Hinweises auf die Patenterteilung: **26.05.2010**
(21) Anmeldenummer: 06778379.5
(22) Anmeldetag: 28.08.2006
(51) Int. Cl.: H01L 51/00

(54) **NEUE MATERIALIEN ZUR VERBESSERUNG DER LOCHINJEKTION IN ORGANISCHEN ELEKTRONISCHEN BAUELEMENTEN UND VERWENDUNG DES MATERIALS**
NOVEL MATERIALS FOR IMPROVING THE HOLE INJECTION IN ORGANIC ELECTRONIC DEVICES AND USE OF THE MATERIAL
NOUVELLES MATIERES POUR AMELIORER L'INJECTION PAR TROUS DANS DES COMPOSANTS ELECTRONIQUES ORGANIQUES ET UTILISATION DE CES MATIERES

(30) Priorität: 05.09.2005 DE 102005042105
(43) Veröffentlichungstag der Anmeldung: 02.07.2008
(73) Patentinhaber: OSRAM Opto Semiconductors GmbH, 93055 Regensburg (DE)
(72) Erfinder: KANITZ, Andreas, 91315 Höchstadt (DE)
(74) Vertreter: Epping - Hermann - Fischer
(86) Internationale Anmeldenummer: PCT/EP2006/065726
(87) Internationale Veröffentlichungsnummer: WO 2007/028733

(56) Entgegenhaltungen:
- US-A1- 2005 139 810
- RUIZ DELGADO M C ET AL: "Vibrational dynamics study of the effect of the substituents on the pi-conjugation of different bithiophene molecules" JOURNAL OF MOLECULAR STRUCTURE, ELSEVIER, AMSTERDAM, NL, Bd. 744-747, 3. Juni 2005 (2005-06-03), Seiten 393-401, XP004892223 ISSN: 0022-2860
- KOJI YUI ET AL: "NOVEL ELECTRON ACCEPTORS BEARING A HETEROQUINONOID SYSTEM. I. SYNTHESIS AND CONDUCTIVE COMPLEXES OF 5,5'-BIS(DICYANOMETHYLENE)-5,5' DIHIDRO-ALPHA 2,2' BITHIOPHENE AND RELATED COMPOUNDS" BULLETIN OF THE CHEMICAL SOCIETY OF JAPAN, CHEMICAL SOCIETY OF JAPAN, TOKYO, JP, Bd. 62, Nr. 5, Mai 1989 (1989-05), Seiten 1539-1546, XP007901263 ISSN: 0009-2673
- PFEIFFER M ET AL: "DOPED ORGANIC SEMICONDUCTORS: PHYSICS AND APPLICATION IN LIGHT EMITTING DIODES" ORGANIC ELECTRONICS, ELSEVIER, AMSTERDAM, NL, Bd. 4, Nr. 2/3, September 2003 (2003-09), Seiten 89-103, XP001177135 ISSN: 1566-1199
- HE GUFENG ET AL: "High-efficiency and low-voltage p-i-n electrophosphorescent organic light-emitting diodes with double-emission layers" APPLIED PHYSICS LETTERS, AIP, AMERICAN INSTITUTE OF PHYSICS, MELVILLE, NY, US, Bd. 85, Nr. 17, 25. Oktober 2004 (2004-10-25), Seiten 3911-3913, XP012063133 ISSN: 0003-6951 in der Anmeldung erwähnt

## Beschreibung

Die Erfindung betrifft neue Materialien zur Verbesserung der Lochinjektion und des Lochtransportes in organischen Bauelementen wie organischen Leuchtdioden (OLEDs), organischen Feldeffekttransistoren (OFETs) und organischen Solarzellen.

In den letzten Jahren sind insbesondere für organische Leuchtdioden Materialien bekannt geworden, durch die die Lochinjektion sowie der Lochtransport in OLEDs signifikant verbessert wird (Lit.: Gufeng He,Martin Pfeiffer, Karl Leo, Appl. Phys. Lett. 85 (2004) 3911-3913).

Dies bewirkt zusätzlich eine Absenkung der Betriebsspannung bei gleicher Effizienz der OLED. Diese Materialien sind starke Elektronenakzeptoren und werden in geringer Menge in die Lochtransportschicht der OLED dotiert. Dadurch erleichtern solche Zusätze die Oxidation des Lochtransportmaterials (also die Lochbildung) was sonst ausschließlich durch die Energie des elektrischen Feldes bewirkt wird. Infolgedessen wird also bei schwächerem, elektrischem Feld (das einer geringeren Betriebsspannung entspricht) die gleiche Effizienz erreicht.

M.C.R. Delgado et al., J. Mol. Struc., 2005, 744-747, 393-401 offenbart ein chinoides Bithiophensystem als Elektronenakzeptor material.

Problematisch sind bei diesem Verfahren zur Verbesserung des Lochtransportes (auch p-Doping genannt), die physikalischen Eigenschaften der einsetzbaren Materialien während des Aufdampfprozesses. Es handelt sich dabei um fluorierte Tetracyano-chinodimethane deren Verdampfbarkeit sehr schlecht steuerbar ist, so dass derartige Dotierstoffe nicht in Anlagen zur Massenfertigung eingesetzt werden können, weil das Material die Anlage durch unkontrollierbare Verteilung verunreinigt.

Aufgabe der Erfindung ist es deshalb, ein Material zur Verbesserung der Lochinjektion in organischen Halbleiterbauelementen
zu schaffen, dass die Nachteile des Standes der Technik, insbesondere die schlechte Steuerbarkeit der bekannten Materialien beim Aufdampfprozess, überwindet.

Die Lösung der Aufgabe und Gegenstand der Erfindung werden in den Ansprüchen, den Beispielen und der Beschreibung offenbart.

Es werden Akzeptormaterialien mit höheren Verdampfungspunkten und/oder mit Glasbildungseigenschaften vorgeschlagen, die deshalb kontrolliert verdampfen. Materialien mit Glasbildungseigenschaften sind amorph und gewährleisten wegen der fehlenden Kristallinität die Aufhebung von Korngrenzen im Material, dass zusätzlich eine energetisch günstigere Elektronen- bzw. Lochübertragung zwischen dem Lochtransportmaterial und dem p-Dotiermaterial bewirkt. Der höhere Verdampfungspunkt bewirkt, dass die Materialien kontrolliert verdampft werden können.

Die geforderten beschriebenen Eigenschaften können mit heterocyclischen Chinodimethanderivaten der folgenden Substruktur 1 erreicht werden.

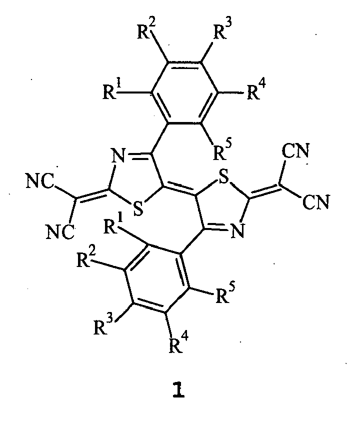

Die Sustituenten R¹ bis R⁵ stehen unabhängig voneinander für Wasserstoff, Chlor, Fluor, Nitro-Gruppe und/oder einen Cyano-rest.

Weiterhin können R¹ bis R⁵ unabhängig voneinander durch Phenylsubstituenten und/oder anellierte aromatische Substituenten bildende Strukturelemente ersetzt sein, die wiederum in ihrer Peripherie außer Wasserstoff auch Chlor und/oder Fluor Substituenten tragen können.

### Allgemeiner Syntheseweg:

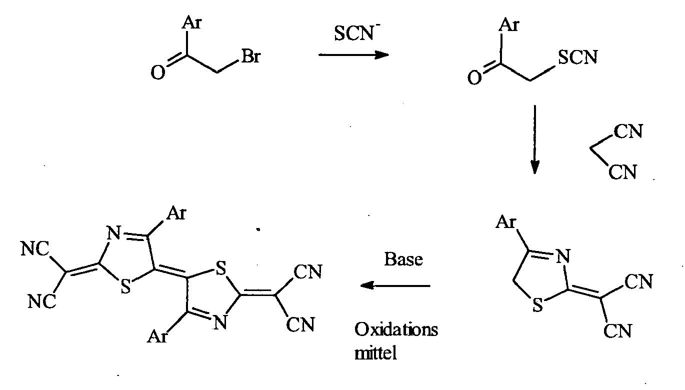

Die Verbindungen werden durch oxydative Kupplung aus den entsprechenden 2-Dicyanomethylen-4-aryl-substituierten Thiazolinen synthetisiert.

Die neuen Materialien, die geeignet sind den Lochtransport und die Lochinjektion durch chemische Wechselwirkung mit beliebigen Lochtransportschichten zu verbessern, können somit universell in polymerelektronischen - oder auch organisch elektronisch genannten - Bauelementen erfolgreich eingesetzt werden, darunter werden vorrangig alle Technologien zur Herstellung von organischen Leuchtdioden (OLEDs), organischen Feldeffekttransistoren (OFETs) und/oder Technologien der organischen Photovoltaik wie der organischen Solarzellen verstanden.

Es werden damit organische elektronische Bauelemente geschaffen, die eine Lochtransportschicht haben, die mit einem Material zur Verbesserung der Lochtransporteigenschaften gedopt oder versetzt sind.

Die Menge, in der die Materialien zugesetzt werden variiert je nach Grundmaterial. Im Großen und Ganzen wird in den üblichen Dotierungsmengen dotiert. Dazu siehe auch die oben in der Einleitung genannte Veröffentlichung zum Stand der Technik.

### Ausführungsbeispiele:

1. Bromierung der Arylmethylketone
   Das entsprechende Arylmethylketon wird mittels Brom in Eisessig bromiert
2. Synthese der Arylacylrhodanide
   Das Brommethyl-Arylketon nach 1.) wird mittels Kaliumrhodanid in siedendem Ethanol umgesetzt.
3. Synthese der 2-Dicyanomethylen-4-aryl-thiazoline
   Das Arylacylrhodanid nach 2.) wird mittels Malonsäuredinitril und Triethylamin in siedendem Ethanol zu dem entsprechenden Thiazolinderivat umgesetzt.
4. Synthese der 4,4'Diaryl-chino-5,5'bisthiazolyl-2,2'-dicyanodimethane
   Das entsprechende Thiazolinderivat nach 3.) wird durch Butyllithium bei -70°C deprotoniert und anschließend mit einem Oxidationsmittel (z.B. CuCl2) zu dem gewünschten 4,4'Diaryl-chino-5,5'bisthiazolyl-2,2'-dicyanodimethan oxidiert.

## Patentansprüche

1. Material zum Doping des Lochtransportlayers eines organischen Halbleiterbauelementen, **dadurch gekennzeichnet, dass** im Material Akzeptoreigenschaften mit einem Verdampfungspunkt oberhalb 150°C und /oder Glasbildungseigenschaften kombiniert vorliegen,
wobei das Material zum Doping ein heterocyclisches Chinodimethanderivat der folgenden Substruktur 1 umfasst 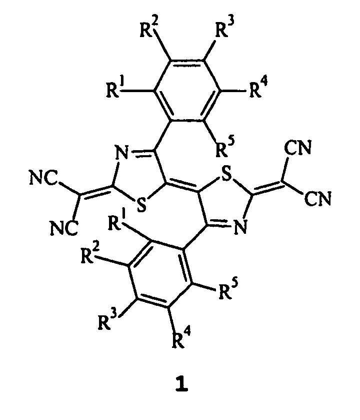 wobei die Substituenten R¹ bis R⁵ unabhängig voneinander wählbar sind und für Wasserstoff, Chlor, Fluor, eine Nitro-Gruppe und/oder einen Cyano-Rest stehen,
oder
die Substituenten R¹ bis R⁵ unabhängig voneinander durch Phenylsubstituenten und/oder anellierte aromatische Substituenten bildende Strukturelemente ersetzt sind, die wiederum in ihrer Peripherie außer Wasserstoff auch Chlor und/oder Fluor Substituenten tragen können.

2. Verwendung eines Materials nach Anspruch 1 in einem organischen elektronischen Bauelement wie beispielsweise in einer organischen Leuchtdiode (OLEDs), einem organischen Feldeffekttransistor (OFETs) und/oder einem Bauelement der organischen Photovoltaik wie einer organischen Solarzelle.

3. Organisches elektronisches Bauelement mit zumindest zwei Elektroden und dazwischen einer aktiven Schicht, wobei zwischen zumindest einer Elektrode und der aktiven Schicht eine Lochtransportschicht angeordnet ist, **dadurch gekennzeichnet, dass** die Lochtranpsortschicht mit einem Material nach Anspruch 1 versetzt ist.

## Claims

1. Material for doping the hole transport layer of an organic semiconductor component, **characterized in that** acceptor properties with a vaporization point above 150°C and/or glass formation properties are present in combination in the material,
said material comprising, for doping, a heterocyclic quinodimethane derivative of the following substructure 1: 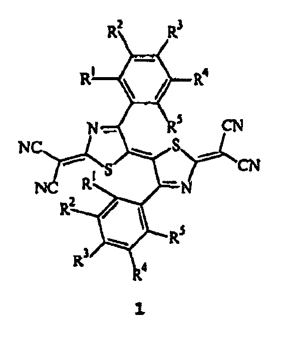 where the substituents R¹ to R⁵ are selectable independently and are each hydrogen, chlorine, fluorine, a nitro group and/or a cyano radical,
or
the substituents R¹ to R⁵ are independently replaced by phenyl substituents and/or structural elements which form fused aromatic substituents and which may in turn, in the periphery thereof, apart from hydrogen, also bear chlorine and/or fluorine substituents.

2. Use of a material according to Claim 1 in an organic electronic component, for example in an organic light-emitting diode (OLED), an organic field-effect transistor (OFET) and/or a component in organic photovoltaics, such as an organic solar cell.

3. Organic electronic component having at least two electrodes and an active layer in between, a hole transport layer being arranged between at least one electrode and the active layer, **characterized in that** the hole transport layer has been crosslinked with a material according to Claim 1.

## Revendications

1. Matériau pour le dopage de la couche de transport des trous d'un composant semi-conducteur organique, **caractérisé en ce que** dans le matériau, il existe de manière combinée, des caractéristiques acceptrices avec un point de vaporisation supérieur à 150°C et /ou des caractéristiques de formation de verre,
dans lequel le matériau pour le dopage comprend un dérivé de chinodimethane hétérocyclique de la structure 1 suivante, 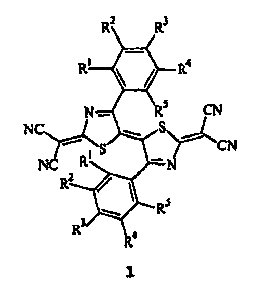 dans lequel les substituants R¹ à R⁵ peuvent être choisis indépendamment les uns des autres et choisis parmi l'hydrogène, le chlore, le fluor, un groupe nitro et/ou un résidu cyano, ou
les substituants R¹ à R⁵ peuvent être remplacés indépendamment les uns des autres par des substituants phényle et/ou des éléments de structure formant des substituants aromatiques fusionnés, qui à nouveau peuvent porter à leur périphérie en plus de l'hydrogène, également des substituants de chlore et/ou de fluor.

2. Utilisation d'un matériau selon la revendication 1 dans un composant électronique organique comme par exemple dans une diode lumineuse organique (OLED), dans un transistor à effet de champ organique (OFET) et/ou un composant photovoltaïque organique comme une cellule solaire organique.

3. Composant électronique organique avec au moins deux électrodes enserrant une couche active, dans lequel une couche de transport des trous est disposée entre au moins une électrode et la couche active, **caractérisé en ce que** la couche de transport des trous incorpore un matériau selon la revendication 1.
